# DEMANDE DE BREVET EUROPEEN

(11) **EP 4 092 746 A1**
(43) Date de publication de la demande: **23.11.2022**
(21) Numéro de dépôt: 22172253.1
(22) Date de dépôt: 09.05.2022
(51) Int. Cl.: H01L 27/146, H01L 31/12, H01L 33/00, H01S 5/026

(54) **PROCÉDÉ DE FABRICATION D'UN DISPOSITIF OPTOÉLECTRONIQUE**

(30) Priorité: 18.05.2021 FR 2105161
(71) Demandeur: Commissariat à l'énergie atomique et aux énergies alternatives, 75015 Paris (FR)
(72) Inventeur: BECKER, Sébastien, 38054 GRENOBLE CEDEX 09 (FR)
(74) Mandataire: Cabinet Beaumont

(57) **Abrégé**

La présente description concerne un procédé de fabrication d'un dispositif optoélectronique, comportant les étapes suivantes :
a) réaliser un dispositif photonique comportant une pluralité de composants photoniques (110)sur un premier substrat ;
b) réaliser un dispositif électronique comportant une couche semiconductrice (125) revêtant un deuxième substrat ;
c) après les étapes a) et b), fixer le dispositif électronique sur le dispositif photonique par collage direct, puis retirer le deuxième substrat ;
d) après l'étape c), former, du côté de la face supérieure du dispositif électronique, des métallisations de connexion électrique,
le procédé comportant en outre :
- après l'étape a) et avant l'étape c), une étape de dépôt d'une couche métallique (111) s'étendant de façon continue sur toute la surface supérieure du dispositif.

## Description

### Domaine technique

La présente description concerne de façon générale la fabrication de dispositifs optoélectroniques. Elle concerne plus particulièrement la fabrication de dispositifs comportant des composants photoniques émetteurs et/ou récepteurs de lumière, intégrés de façon monolithique sur un circuit intégré microélectronique, par exemple de type CMOS (de l'anglais "Complementary Metal Oxide Semiconductor" - métal-oxyde semiconducteur complémentaire).

### Technique antérieure

Diverses solutions ont été proposées pour intégrer de façon monolithique des composants photoniques émetteur et/ou récepteurs de lumière sur un circuit microélectronique de type CMOS.

Les solutions connues présentent toutefois divers inconvénients et/ou diverses limitations qu'il serait souhaitable de pallier en tout ou partie.

### Résumé de l'invention

Un mode de réalisation prévoit un procédé de fabrication d'un dispositif optoélectronique, comportant les étapes suivantes :
a) réaliser un dispositif photonique comportant une pluralité de composants photoniques formés dans et sur un empilement d'une ou plusieurs couches semiconductrices revêtant un premier substrat ;
b) réaliser un dispositif électronique comportant une couche semiconductrice revêtant un deuxième substrat ;
c) après les étapes a) et b), fixer le dispositif électronique sur la face supérieure du dispositif photonique par collage direct, puis retirer le deuxième substrat ;
d) après l'étape c), former, du côté de la face supérieure du dispositif électronique, des métallisations de connexion électrique contactant des composants électroniques du dispositif électronique et les composants photoniques,
le procédé comportant en outre :
- après l'étape a) et avant l'étape c), une étape de dépôt d'une couche métallique s'étendant de façon continue sur toute la surface supérieure du dispositif photonique ; et
- après l'étape c), une étape de formation, à partir de la face supérieure du dispositif électronique, d'une pluralité de tranchées isolantes s'étendant verticalement à travers le dispositif électronique et la couche métallique, lesdites tranchées isolantes délimitant dans la couche métallique une pluralité d'électrodes isolées électriquement les unes des autres.

Selon un mode de réalisation, le procédé comporte, avant l'étape c), la formation d'une pluralité de composants électroniques dans et sur la couche semiconductrice revêtant le deuxième substrat.

Selon un mode de réalisation, le procédé comporte en outre, après l'étape c), la formation d'une pluralité de composants électroniques dans et sur la couche semiconductrice.

Selon un mode de réalisation, à l'étape c), le dispositif électronique est fixé sur la face supérieure du dispositif photonique par collage direct pleine plaque métal-métal, diélectrique-diélectrique, ou semiconducteur-semiconducteur.

Selon un mode de réalisation, le procédé comporte en outre, après l'étape d), une étape de formation d'un empilement d'interconnexion du côté de la face supérieure du dispositif électronique.

Selon un mode de réalisation, le procédé comporte en outre, après l'étape d), une étape de fixation, du côté de la face supérieure du premier dispositif électronique, d'un deuxième dispositif électronique comportant une pluralité de composants électroniques formés dans et sur une couche semiconductrice revêtant un troisième substrat.

Selon un mode de réalisation, les composants photoniques comprennent des diodes photosensibles et/ou des LED.

Selon un mode de réalisation, les composants photoniques comprennent des microbolomètres.

Selon un mode de réalisation, l'étape a) comprend une étape de report et de fixation d'un premier empilement actif photonique sur un deuxième empilement actif photonique.

Selon un mode de réalisation, le procédé comporte, après la fixation du premier empilement actif photonique sur le deuxième empilement actif photonique et avant l'étape c), une étape de formation d'un via conducteur isolé traversant le premier empilement actif photonique et contactant le deuxième empilement actif photonique.

Selon un mode de réalisation, le premier empilement actif photonique est un empilement actif de diode photosensible et le deuxième empilement actif photonique est un empilement actif de LED.

Selon un mode de réalisation, le procédé comporte la réalisation d'une métallisation de contact de cathode commune au premier empilement actif photonique et au deuxième empilement actif photonique.

Selon un mode de réalisation, le premier empilement actif photonique est fixé sur le deuxième empilement actif photonique par collage direct métal-métal ou par collage direct diélectrique-diélectrique ou par collage direct semiconducteur-semiconducteur.

Selon un mode de réalisation, le procédé comporte, avant la fixation du premier empilement actif photonique sur le deuxième empilement actif photonique, une étape de dépôt d'une couche métallique sur et en contact avec la face supérieure du deuxième empilement actif photonique.

Selon un mode de réalisation, lors de la fixation du premier empilement actif photonique sur le deuxième empilement actif photonique, ladite couche métallique s'étend de façon continue sur toute la surface du deuxième empilement actif photonique.

Selon un mode de réalisation, avant la fixation du premier empilement actif photonique sur le deuxième empilement actif photonique, la couche métallique est retirée localement par gravure de façon à définir une pluralité d'électrodes disjointes.

Selon un mode de réalisation, le dispositif photonique comprend un capteur visible et un capteur infrarouge superposés, le capteur visible étant formé dans et sur une couche semiconductrice et le capteur infrarouge étant formé dans et sur un empilement actif de détecteur infrarouge.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B, 1C, 1D, 1E, 1F, 1G, 1H, 1I, 1J et 1K sont des vues en coupe illustrant des étapes d'un exemple d'un procédé de fabrication d'un dispositif optoélectronique selon un mode de réalisation ;
les figures 2A et 2B sont des vues en coupe illustrant des étapes d'un autre exemple d'un procédé de fabrication d'un dispositif optoélectronique selon un mode de réalisation ;
les figures 3A et 3B sont des vues en coupe illustrant des étapes d'un autre exemple d'un procédé de fabrication d'un dispositif optoélectronique selon un mode de réalisation ;
les figures 4A, 4B, 4C, 4D, 4E, 4F et 4G sont des vues en coupe illustrant des étapes d'un autre exemple d'un procédé de fabrication d'un dispositif optoélectronique selon un mode de réalisation ;
la figure 5 est une vue en coupe illustrant un autre exemple d'un procédé de fabrication d'un dispositif optoélectronique selon un mode de réalisation ;
les figures 6A et 6B sont des vues en coupe illustrant des étapes d'un autre exemple d'un procédé de fabrication d'un dispositif optoélectronique selon un mode de réalisation ;
les figures 7A, 7B, 7C et 7D sont des vues en coupe illustrant des étapes d'un autre exemple d'un procédé de fabrication d'un dispositif optoélectronique selon un mode de réalisation ;
les figures 8A, 8B et 8C sont des vues en coupe illustrant des étapes d'un autre exemple d'un procédé de fabrication d'un dispositif optoélectronique selon un mode de réalisation ;
les figures 9A, 9B, 9C et 9D sont des vues en coupe illustrant des étapes d'un autre exemple d'un procédé de fabrication d'un dispositif optoélectronique selon un mode de réalisation ;
les figures 10A, 10B, 10C et 10D sont des vues en coupe illustrant des étapes d'un autre exemple d'un procédé de fabrication d'un dispositif optoélectronique selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des composants photoniques émetteurs et/ou récepteurs de lumière et des circuits intégrés de contrôle des dispositifs décrits n'a pas été détaillée, la réalisation détaillée de ces éléments étant à la portée de la personne du métier à partir des indications de la présente description. De plus, les diverses applications que peuvent avoir les dispositifs décrits n'ont pas été détaillées.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Selon un aspect d'un mode de réalisation, on prévoit, pour réaliser un dispositif optoélectronique comportant des composants photoniques unitaires aussi appelés pixels, émetteurs et/ou récepteurs de lumière, intégrés de façon monolithique sur un circuit intégré de contrôle, par exemple de type CMOS, de mettre en oeuvre les étapes suivantes :
a) réaliser un dispositif photonique comportant une pluralité de composants photoniques formés dans et sur un empilement d'une ou plusieurs couches semiconductrices revêtant un premier substrat ;
b) réaliser un dispositif électronique comportant une pluralité de composants électroniques, par exemple des transistors MOS, formés dans et sur une couche semiconductrice revêtant un deuxième substrat ;
c) après les étapes a) et b), fixer le dispositif électronique sur la face supérieure du dispositif photonique par collage direct, puis retirer le deuxième substrat ;
d) après l'étape c), former, du côté de la face supérieure du dispositif électronique, des métallisations de connexion électrique contactant les composants électroniques et les composants photoniques.

De préférence, après l'étape a) et avant l'étape c), une couche métallique est déposée sur la face supérieure du dispositif photonique, cette couche métallique s'étendant de façon continue sur toute la surface du premier substrat. Après l'étape c), on prévoit alors une étape de gravure, à partir de la face supérieure du dispositif électronique, d'une pluralité de tranchées s'étendant verticalement à travers le dispositif électronique et la couche métallique, les tranchées délimitant dans la couche métallique une pluralité d'électrodes isolées électriquement les unes des autres.

Des exemples de mise en oeuvre de tels procédés vont être décrits ci-après. Ces exemples sont non limitatifs et diverses variantes apparaîtront à la personne du métier à partir des indications de la présente description.

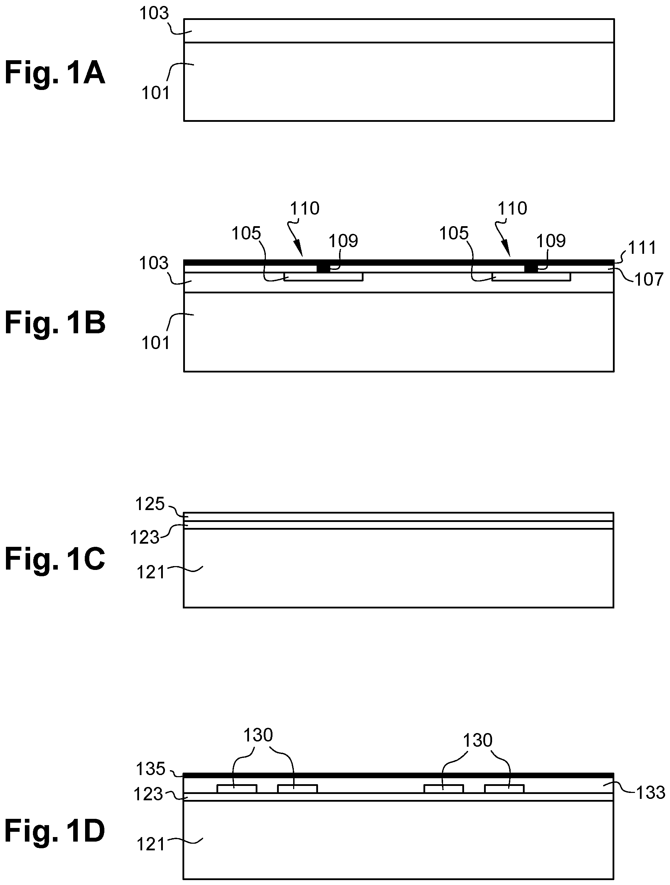

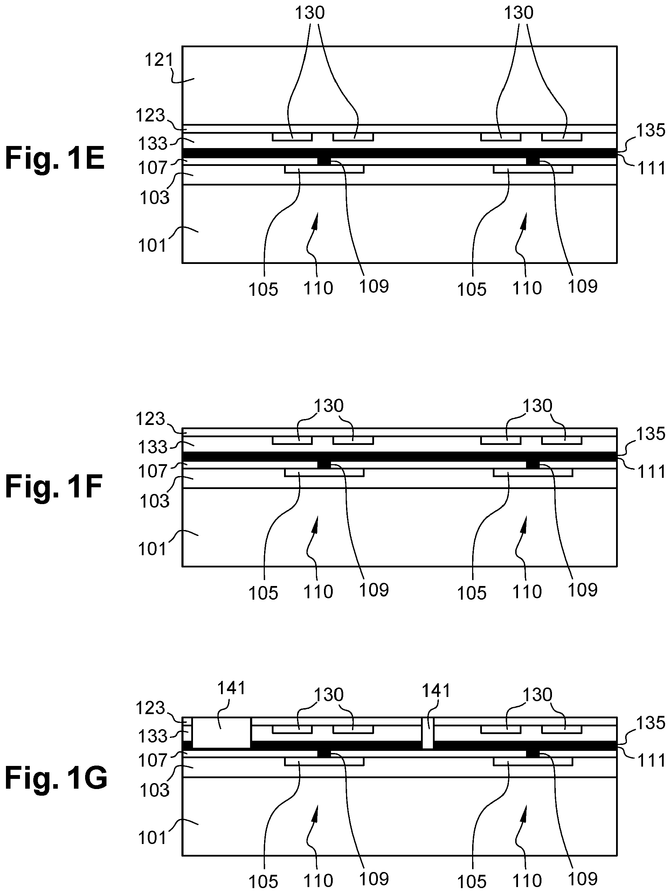

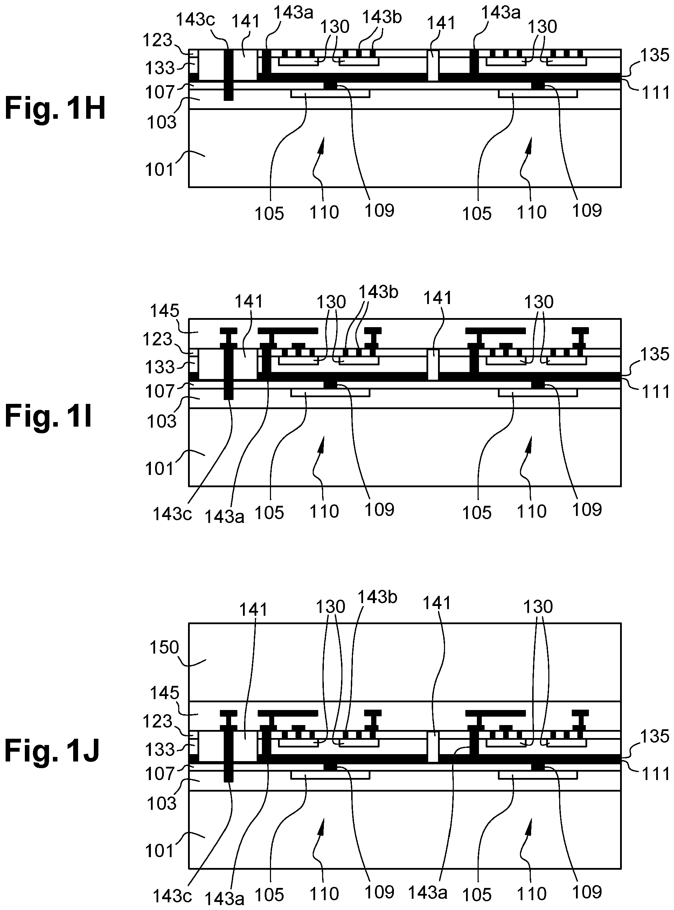

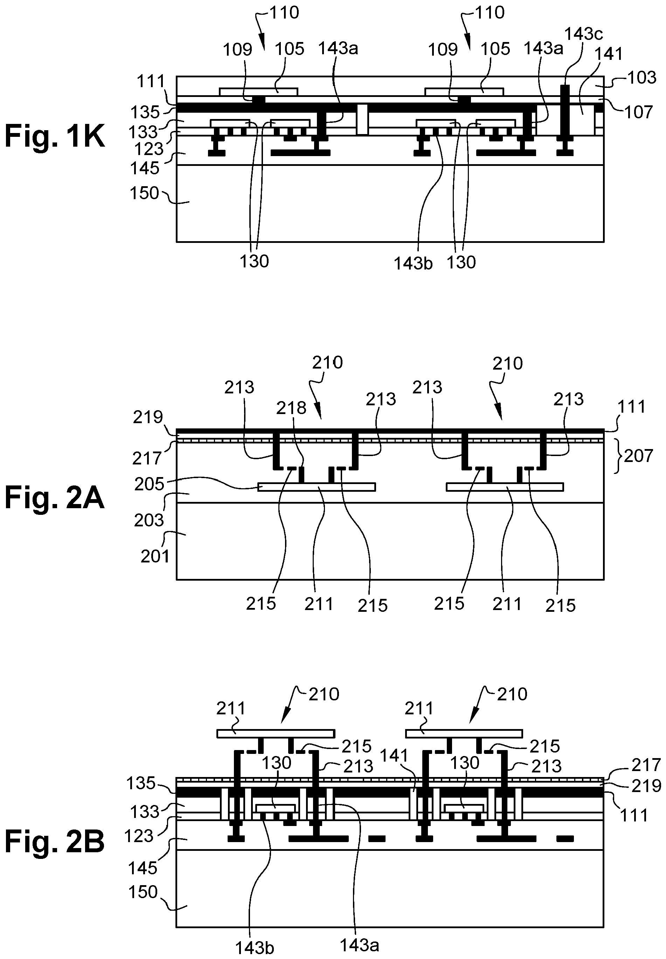

Les figures 1A, 1B, 1C, 1D, 1E, 1F, 1G, 1H, 1I, 1J et 1K sont des vues en coupe illustrant des étapes d'un exemple d'un procédé de fabrication d'un dispositif optoélectronique selon un mode de réalisation.

La figure 1A illustre une structure de départ pour la formation du dispositif photonique, comportant un substrat 101 revêtu, du côté de sa face supérieure, d'un empilement photonique 103. L'empilement photonique 103 peut comprendre une ou plusieurs couches semiconductrices superposées, par exemple une ou plusieurs couches en des matériaux semiconducteurs de type III-V. L'empilement 103 est par exemple un empilement actif de photodiode, par exemple sensible dans l'infrarouge ou le proche infrarouge, ou un empilement actif de photodiode sensible dans le visible. A titre d'exemple, l'empilement 103 comprend une couche en phosphure d'indium (InP) non intentionnellement dopé, une couche d'absorption en arséniure d'indium-gallium (InGaAs), par exemple relativement faiblement dopé de type N, et une couche en phosphure d'indium (InP) relativement fortement dopé de type N (non détaillées sur la figure). A titre de variante, l'empilement 103 peut être un empilement actif de diode électroluminescente (LED).

Le substrat 101 est par exemple en silicium. A titre d'exemple, l'empilement 103 est d'abord formé par épitaxie sur un substrat de croissance, par exemple en phosphure d'indium, puis reporté et fixé sur le substrat 101, par exemple par collage direct, le substrat de croissance étant ensuite retiré ou aminci. En pratique, le substrat 101 peut avoir des dimensions latérales supérieures à celles du substrat de croissance. Dans ce cas, plusieurs vignettes de l'empilement 103 (non détaillées sur les figures) peuvent être reportées et fixées sur le même substrat 101, de façon à reconstruire un empilement 103 de plus grandes dimensions latérales, par exemple tel que décrit dans l'article intitulé "High-definition Visible-SWIR InGaAs Image Sensor using Cu-Cu Bonding of III-V to Silicon Wafer" de S. Manda et al. (IEDM 2019). Après la fixation des vignettes, un nivellement de la surface avec une couche diélectrique, par exemple un oxyde, peut être prévu pour obtenir une surface plane.

La figure 1B illustre la structure obtenue à l'issue d'étapes de formation de composants photoniques élémentaires dans l'empilement 103. Dans l'exemple représenté, les composants photoniques élémentaires sont des diodes photosensibles 110. Pour chaque diode photosensible 110, on vient former une région localisée dopée de type P 105 dans une couche supérieure de type N de l'empilement 103, la région 105 définissant une région d'anode de la diode photosensible. Pour cela, une couche diélectrique 107, par exemple en nitrure de silicium ou en oxyde de silicium, est d'abord déposée sur la face supérieure de l'empilement 103. Des ouvertures localisées sont ensuite formées dans la couche diélectrique 107 en vis-à-vis des futures régions d'anode 105. Les régions 105 sont ensuite dopées de type P, par diffusion ou implantation d'éléments dopants de type P, par exemple du zinc (Zn) ou du béryllium (Be), en vis-à-vis des ouvertures. Des recuits d'activation des éléments dopants peuvent ensuite être mis en oeuvre. Des métallisations de reprise de contact 109, par exemple en tungstène, en cuivre, en aluminium, ou en un alliage d'un ou plusieurs de ces matériaux, sont ensuite formées dans les ouvertures, par exemple par un procédé de type damascène, de façon à obtenir une surface supérieure plane (autrement dit les métallisations 109 affleurent au niveau de la face supérieure de la couche diélectrique 107). Chaque métallisation 109 peut comporter une couche périphérique barrière à la diffusion du métal, par exemple un empilement titane/nitrure de titane ou un empilement tantale/nitrure de tantale. Chaque métallisation 109 est en contact, par sa face inférieure, avec la face supérieure de la région d'anode 105 sous-jacente. A titre de variante, le dopage localisé des régions 105 peut être réalisé par implantation à travers la couche diélectrique 107, avant la réalisation des ouvertures dans la couche diélectrique 107. Ceci permet d'éviter d'éventuelles dégradations de la surface supérieure de l'empilement 103 liées au procédé d'implantation.

La figure 1B illustre en outre une étape de dépôt d'une couche métallique 111, par exemple en titane, sur la face supérieure du dispositif photonique ainsi obtenu. La couche 111 s'étend par exemple de façon continue et avec une épaisseur sensiblement uniforme sur toute la surface du substrat 101. Dans cet exemple, la couche métallique 111 est en contact, par sa face inférieure, avec la face supérieure de la couche diélectrique 107, et avec la face supérieure des métallisations 109. Ainsi, à ce stade, les métallisations de contact d'anode 109 des diodes sont toutes connectées les unes aux autres par l'intermédiaire de la couche métallique 111.

La figure 1C illustre une structure de départ pour la formation du dispositif électronique, par exemple en technologie CMOS. La structure de la figure 1C est une structure de type silicium sur isolant aussi appelée structure SOI, de l'anglais "Silicon on Insulator", comportant un substrat 121, par exemple en silicium, une couche diélectrique 123, par exemple en oxyde de silicium, sur et en contact avec la face supérieure du substrat 121, et une couche semiconductrice 125, par exemple en silicium, sur et en contact avec la face supérieure de la couche diélectrique 123. A ce stade, les couches diélectrique 123 et semiconductrice 125 s'étendent par exemple chacune de façon continue et avec une épaisseur sensiblement uniforme sur toute la surface supérieure du substrat 121. Le substrat 121 a par exemple sensiblement la même forme et les mêmes dimensions latérales que le substrat 101 des figures 1A et 1B. A titre d'exemple, le substrat 121 a une forme générale circulaire de diamètre de l'ordre de 200 mm ou de l'ordre de 300 mm.

La figure 1D illustre la structure obtenue à l'issue d'étapes de formation de composants électroniques 130, par exemple des transistors MOS, dans et sur la couche semiconductrice 125. La formation des composants 130 peut comprendre une ou plusieurs étapes d'implantation localisée d'éléments dopants dans la couche semiconductrice 125, ainsi qu'un ou plusieurs recuits d'activation des éléments dopants. La formation des composants 130 peut en outre comprendre des étapes de dépôt et de gravure d'une couche d'isolant de grille et d'une ou plusieurs couches conductrices de grille de transistors MOS. Par soucis de simplification, les différents éléments des composants 130 n'ont pas été détaillés sur les figures.

A titre d'exemple, la couche semiconductrice 125 peut être gravée sur toute son épaisseur autour des composants 130, de façon à isoler latéralement les composants 130 les uns des autres. Dans l'exemple représenté, après la formation des composants 130, une couche isolante de passivation 133, par exemple en oxyde de silicium, est déposée sur toute la surface supérieure du dispositif, par exemple sur une épaisseur supérieure à celle des composants 130. Une étape de planarisation de la face supérieure de la couche isolante 133 peut en outre être mise en oeuvre.

La figure 1D illustre en outre une étape de dépôt d'une couche métallique 135, par exemple en le même matériau que la couche 111 (figure 1B), par exemple en titane, sur la face supérieure du dispositif électronique ainsi obtenu. La couche 135 s'étend par exemple de façon continue et avec une épaisseur sensiblement uniforme sur toute la surface du substrat 121. Dans cet exemple, la couche métallique 135 est en contact, par sa face inférieure, avec la face supérieure de la couche diélectrique 133.

La figure 1E illustre une étape ultérieure de report et de fixation du dispositif électronique de la figure 1D sur la face supérieure du dispositif photonique de la figure 1B. Sur la figure 1E, le dispositif électronique est retourné par rapport à l'orientation de la figure 1D. L'orientation du dispositif photonique est en revanche inchangée par rapport à l'orientation de la figure 1B.

Le dispositif électronique est fixé sur le dispositif photonique par collage direct (c'est-à-dire sans apport de matière), aussi appelé collage moléculaire, de la face inférieure de la couche métallique 135 sur la face supérieure de la couche métallique 111.

La figure 1F illustre une étape ultérieure de retrait du substrat semiconducteur 121 du dispositif électronique, par exemple par meulage puis gravure chimique pleine plaque (par exemple une gravure sélective par rapport au matériau de la couche diélectrique 123), de façon à libérer l'accès à la face supérieure de la couche diélectrique 123.

La figure 1G illustre la structure obtenue à l'issue d'une étape ultérieure de gravure de tranchées verticales 141 à partir de la face supérieure de la couche diélectrique 123. Les tranchées 141 traversent les couches diélectriques 123 et 133 et les couches métalliques 135 et 111 et débouchent dans la couche diélectrique 107 ou sur la face supérieure de la couche diélectrique 107. Les tranchées 141 sont ensuite remplies d'un matériau isolant, par exemple de l'oxyde de silicium, puis une étape de planarisation de la face supérieure de l'assemblage peut être mise en oeuvre, par exemple par polissage mécano-chimique (CMP). A titre de variante, une couche d'arrêt de CMP, non représentée, peut être déposée sur la face supérieure de la couche diélectrique 123 préalablement à la gravure des tranchées 141. Dans une autre variante, le matériau diélectrique de remplissage des tranchées 141 (par exemple du nitrure de silicium) peut être un matériau différent de celui de la couche diélectrique 123 (par exemple de l'oxyde de silicium), la couche 123 faisant alors office de couche d'arrêt de CMP.

Les tranchées isolantes 141 délimitent une pluralité de métallisations disjointes, c'est-à-dire à dire isolées électriquement les unes des autres, dans l'empilement formé par les couches métalliques 111 et 135. A titre d'exemple, les tranchées 141 délimitent latéralement une métallisation spécifique par diode photosensible du dispositif photonique, ladite métallisation, aussi appelée métallisation d'anode, étant connectée à la métallisation de reprise de contact d'anode 109 de la diode.

Les tranchées s'étendent entre les composants électroniques 130 du dispositif électronique.

La figure 1H illustre la structure obtenue à l'issue d'étapes ultérieures de formation de vias conducteurs de reprise de contact, à partir de la face supérieure de la structure de la figure 1G. Lors de cette étape, on vient former des vias conducteurs de reprise de contact sur les différents composants photoniques et électroniques de l'assemblage. Dans l'exemple représenté, un via conducteur 143a s'étendant verticalement à travers les couches isolantes 123 et 133 vient contacter individuellement, par sa face supérieure, chaque métallisation d'anode du dispositif. De plus, pour chaque composant électronique 130, un ou plusieurs vias conducteurs 143b s'étendant verticalement à travers la couche isolante 123 viennent contacter des régions de contact du composant électronique, par exemple des régions de grille, de drain et/ou de source dans le cas de transistors MOS. Dans l'exemple représenté, un ou plusieurs vias conducteurs 143c s'étendant verticalement à travers une tranchée isolante 141 et à travers la couche diélectrique 107 sous-jacente viennent contacter une région semiconductrice de cathode de l'empilement 103. Bien que non détaillée sur les figures, une couche d'isolation latérale, par exemple en oxyde de silicium, peut revêtir les parois latérales des vias 143c de façon à éviter de court-circuiter les différentes couches de l'empilement 103. Le contact électrique est alors pris au fond du via, dans ou sur une couche semiconductrice de type N de l'empilement 103, formant la région de cathode des composants photosensibles. La couche d'isolation latérale est par exemple déposée par un procédé de dépôt conforme, puis ouverte au fond des vias par gravure anisotrope verticale.

A titre d'exemple, un contact de cathode commun à toutes les diodes photosensibles du dispositif peut être réalisé en périphérie du dispositif. A titre d'exemple, le contact de cathode commun relie des composants électroniques du dispositif à une couche dopée de type N de l'empilement 103.

La figure 1I illustre la structure obtenue à l'issue d'étapes ultérieures de formation d'un empilement d'interconnexion 145 sur et en contact avec la face supérieure de la structure de la figure 1I. L'empilement d'interconnexion 145 comprend une alternance de niveaux isolants et conducteurs définissant des pistes et vias d'interconnexion et de routage des différents composants du dispositif.

La figure 1J illustre une étape de fixation d'un substrat ou poignée de support 150, par exemple un substrat en silicium, sur la face supérieure de l'empilement d'interconnexion 145. Le substrat de support 150 peut être fixé par collage direct ou par toute autre méthode de collage adaptée, par exemple par collage au moyen d'un polymère adhésif.

La figure 1K illustre le dispositif optoélectronique obtenu après une étape de retrait du substrat 101 du dispositif photonique, par exemple par meulage puis gravure chimique pleine plaque, de façon à libérer l'accès à la face de l'empilement 103 opposée à la couche diélectrique 107. Sur la figure 1K, le dispositif est retourné par rapport à l'orientation de la figure 1J.

Après cette étape, des plots de connexion d'alimentation électrique peuvent être formés du côté de la face supérieure du dispositif. Pour cela, l'empilement 103 peut être gravé localement sur toute son épaisseur, jusqu'à exposer la face supérieure de la couche métallique 111. Des plots de connexion d'alimentation électrique en contact, par leur face inférieure, avec la face supérieure de la couche métallique 111, sont alors formés dans les ouvertures ainsi réalisées. A titre de variante, les couches métalliques 111 et 135 peuvent être retirées lors de la gravure, le contact étant alors pris directement sur la face supérieure de vias 143a.

Un avantage du procédé décrit en relation avec les figures 1A à 1K est lié au fait que, lors de l'étape de collage du dispositif électronique sur le dispositif photonique, les couches métalliques 111 et 135 s'étendent chacune sur toute la surface de l'assemblage. Le collage réalisé est donc un collage direct pleine plaque. Un tel collage présente l'avantage d'être moins contraignant, notamment en termes de design et de préparation des surfaces à coller, qu'un collage direct hybride, c'est-à-dire un collage d'une surface hybride métal/oxyde sur une autre surface hybride métal/oxyde. Ceci permet par exemple une meilleure tolérance à un désalignement des vignettes de l'empilement 103 par rapport au dispositif électronique.

Le procédé décrit ci-dessus permet en outre d'optimiser la performance des dispositifs photoniques en s'affranchissant d'étapes de gravure de tranchées profondes à travers l'empilement photonique 103, et en réalisant l'isolation des pixels par la face arrière (face supérieure dans l'orientation des figures 1F et 1G), après collage du dispositif électronique.

Le procédé décrit ci-dessus permet en outre de limiter le budget thermique vu par les composants photoniques dans la mesure où les composants électroniques (par exemple des transistors MOS) sont réalisés avant le collage du dispositif électronique sur le dispositif photonique. En particulier, les étapes d'implantation et d'activation des éléments dopants, pouvant impliquer des recuits à des températures élevées, par exemple de l'ordre de 1000°C ou plus, sont mises en oeuvre avant le collage. Après le collage, seules subsistent des étapes à relativement basse température, par exemple inférieures à 450°C, pour la réalisation des interconnexions électriques.

A titre de variante, plutôt que de former les composants électroniques 130 (par exemple des transistors MOS) avant l'assemblage du dispositif électronique et du dispositif photonique (figure 1E), les composants électroniques 130 peuvent être réalisés après le collage du dispositif électronique sur le dispositif photonique et le retrait du substrat 121, selon un procédé de type 3D séquentiel, par exemple tel que décrit dans la demande de brevet US2007/0018075, avec pour particularité la présence d'une couche métallique 111, 135 pleine plaque sous la couche semiconductrice 125, et la réalisation de tranchées d'isolation s'étendant à travers ladite couche métallique. Dans cette variante, on utilisera de préférence, pour former les composants électroniques 130, des procédés présentant un budget thermique limité, par exemple des procédés dits basse température, c'est-à-dire comportant uniquement des étapes à des températures inférieures à 600°C, et de préférence inférieures à 450°C.

Les figures 2A et 2B sont des vues en coupe illustrant un autre exemple d'un procédé de fabrication d'un dispositif optoélectronique selon un mode de réalisation.

Le procédé des figures 2A et 2B diffère du procédé décrit en relation avec les figures 1A à 1K principalement en ce que, dans l'exemple des figures 2A et 2B, le dispositif photonique est un capteur infrarouge à base de microbolomètres.

La figure 2A illustre le dispositif photonique après le dépôt de la couche métallique de collage 111 et avant le collage du dispositif électronique.

Le dispositif photonique de la figure 2A peut être réalisé par toute méthode connue de fabrication d'un capteur infrarouge à base de microbolomètres, par exemple à partir d'une structure de type SOI comportant un substrat semiconducteur de support 201, par exemple en silicium, une couche isolante 203, par exemple en oxyde de silicium, disposée sur et en contact avec la face supérieure du substrat 201, et une couche semiconductrice 205, par exemple en silicium, disposée sur et en contact avec la face supérieure de la couche semiconductrice 205.

Dans l'exemple représenté, chaque microbolomètre 210 comprend une membrane 211 constituée par une portion de la couche semiconductrice 205. Chaque microbolomètre 210 comprend en outre des piliers métalliques 213 et 218 et des bras 215 de suspension mécanique de la membrane 211. Les bras de suspension 215 sont constitués d'un empilement de couches diélectriques et métalliques et assurent avec les piliers 213 et 218 une fonction de connexion électrique à des régions de prise de contact de la membrane. Les piliers métalliques 213, 218 et les bras de suspension mécanique 215 sont formés dans un empilement 207 de couches isolantes et de couches métalliques disposé sur et en contact avec la face supérieure de la couche semiconductrice 205. Les piliers métalliques 218 sont en contact, par leur face inférieure, avec la face supérieure de la membrane 211 et, par leur face supérieure, avec la face inférieure d'une couche métallique des bras de suspension 215. Les piliers métalliques 213 sont en contact, par leur face inférieure, avec la face supérieure d'une couche métallique des bras 215. Les couches isolantes de l'empilement 207 sont par exemple en oxyde de silicium.

Dans l'exemple représenté, l'empilement 207 est revêtu par une couche d'arrêt de gravure 217 en un matériau diélectrique, par exemple en alumine (Al₂O₃) ou en nitrure d'aluminium (AlN). La couche 217 est par exemple disposée sur et en contact avec la face supérieure de l'empilement 207. Dans cet exemple, la couche 217 est elle-même revêtue par une couche isolante 219, par exemple en oxyde de silicium. La couche 219 est par exemple disposée sur et en contact avec la face supérieure de la couche d'arrêt de gravure 217. Dans cet exemple, les piliers métalliques de support 213 de chaque microbolomètre se prolongent à travers les couches 217 et 219 et débouchent du côté la face supérieure de la couche isolante 219.

Dans cet exemple, la couche métallique de collage 111, par exemple en titane, s'étend de façon continue et avec une épaisseur sensiblement uniforme sur toute la surface supérieure du dispositif photonique. Plus particulièrement, dans cet exemple, la couche métallique de collage 111 est en contact, par sa face supérieure, avec la face supérieure de la couche isolante 219 et avec la face supérieure des piliers métalliques de support 213. Ainsi, à ce stade, les piliers métalliques 213 des microbolomètres sont tous connectés les uns aux autres par l'intermédiaire de la couche métallique 111.

La suite du procédé est similaire à ce qui a été décrit ci-dessus en relation avec les figures 1A à 1K, en substituant au dispositif photonique à base de photodiodes de la figure 1B le dispositif photonique à base de photodétecteurs de la figure 2A.

Dans cet exemple, les tranchées isolantes 141 délimitent une pluralité de métallisations disjointes dans l'empilement formé par les couches métalliques 111 et 135, chaque métallisation étant par exemple connectée à un unique pilier métallique de support 213. Les tranchées 141 permettent en outre de définir, sous chaque membrane, des zones métalliques non connectées aux piliers, ayant pour fonction de réfléchir le rayonnement électromagnétique reçu afin d'améliorer la performance des microbolomètres.

Les vias conducteurs 143 comprennent des vias 143a venant contacter respectivement les différents piliers métallique 213 (par l'intermédiaire des portions des couches métalliques 111 et 135 délimitées par les tranchées 141), et des vias 143b venant contacter des régions de contact des composants électroniques 130.

Après la fixation de la poignée de support 150 sur la face de l'empilement d'interconnexion 145 opposée au dispositif photonique (correspondant à l'étape de la figure 1J), le substrat 201 est retiré de façon à exposer la couche isolante 203 de la structure SOI de départ. Dans cet exemple, ainsi que dans les exemples décrits précédemment, la couche enterrée d'oxyde de silicium 203 du substrat SOI de départ permet de faciliter le retrait du substrat de support en silicium.

La couche isolante 203 ainsi que les couches isolantes de l'empilement 207 sont ensuite retirées par un procédé de gravure sélectif de façon à conserver uniquement les membranes 211, les piliers métalliques 213 et 218, et les bras de suspension 215 des microbolomètres. Les membranes 211 se retrouvent alors suspendues sur les piliers et les bras métalliques de support. La gravure mise en oeuvre pour libérer les microbolomètres est de préférence une gravure chimique en phase vapeur, par exemple une gravure à base d'acide fluoridrique. Dans cet exemple, la couche 217 sert de couche d'arrêt de gravure, pour éviter notamment de consommer l'oxyde de silicium de la couche isolante 219 et des tranchées 141 et pour protéger les composants électroniques du dispositif.

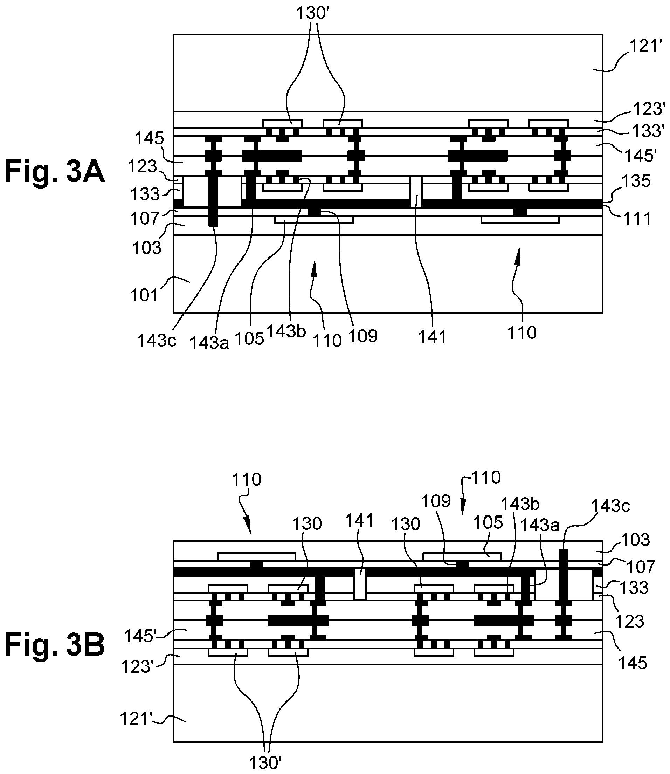

Les figures 3A et 3B sont des vues en coupe illustrant des étapes d'un autre exemple d'un procédé de fabrication d'un dispositif optoélectronique selon un mode de réalisation.

Le procédé des figures 3A et 3B diffère du procédé décrit en relation avec les figures 1A à 1K principalement en ce que, dans l'exemple des figures 3A et 3B, un deuxième dispositif électronique, par exemple réalisé en technologie CMOS, est fixé et connecté électriquement au dispositif électronique comportant les composants 130. Pour cela, après les étapes des figures 1A à 1I, au lieu de fixer une poignée de support 150 sur la face supérieure de l'empilement d'interconnexion 145 tel que décrit, en relation avec la figure 1J, on vient fixer le deuxième dispositif électronique sur la face supérieure de l'empilement 145.

Cette étape est illustrée par la figure 3A. Le deuxième dispositif électronique est par exemple similaire au premier dispositif électronique. Dans l'exemple représenté, le deuxième dispositif électronique est formé à partir d'une structure SOI comportant un substrat 121' revêtu d'une couche isolante 123', elle-même revêtue d'une couche semiconductrice dans et sur laquelle sont formés des composants 130', par exemple des transistors MOS. Le deuxième dispositif électronique comprend en outre, du côté de la couche semiconductrice opposée au substrat 121', un empilement d'interconnexion 145' ayant une face de connexion (face inférieure dans l'orientation de la figure 3A) symétrique par rapport à la face de connexion (face supérieure dans l'orientation de la figure 3A) de l'empilement d'interconnexion 145 du premier dispositif électronique.

Le deuxième dispositif électronique est fixé et connecté électriquement au premier dispositif électronique, par exemple par collage direct hybride de la face de l'empilement d'interconnexion 145' opposée au substrat 121' (à savoir la face inférieure de l'empilement 145' dans l'orientation de la figure 3A) sur la face de l'empilement 145 opposée au substrat 101 (à savoir la face supérieure de l'empilement 145 dans l'orientation de la figure 3A). Le collage peut être un collage direct hybride de type cuivre oxyde.

Une fois le collage réalisé, le substrat 101 peut être retiré, tel que décrit en relation avec la figure 1K. Cette étape est illustrée par la figure 3B.

Un avantage du procédé des figures 3A et 3B est qu'il permet d'augmenter les fonctionnalités électroniques du dispositif, sans augmenter sa surface. La variante des figures 3A et 3B peut être combinée à la variante des figures 2A et 2B.

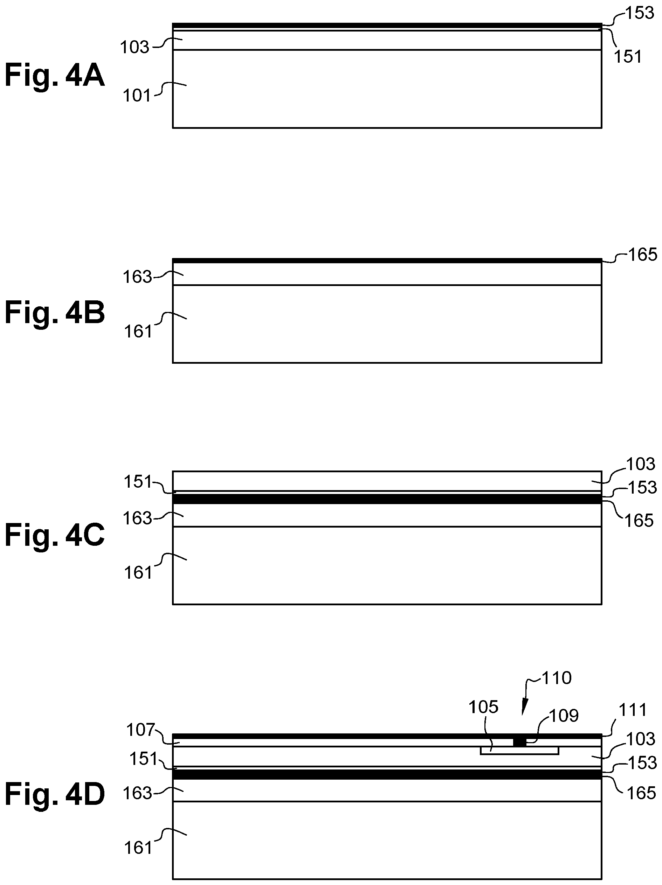

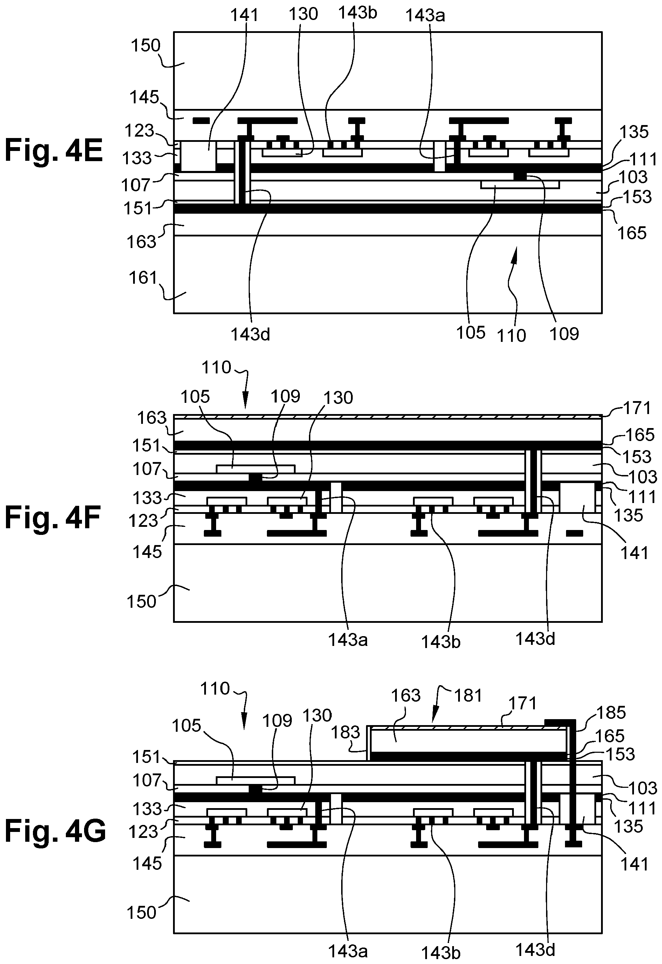

Les figures 4A, 4B, 4C, 4D, 4E, 4F et 4G sont des vues en coupe illustrant des étapes d'un autre exemple d'un procédé de fabrication d'un dispositif optoélectronique selon un mode de réalisation.

Le procédé des figures 4A à 4G diffère du procédé des figures 1A à 1K principalement en ce que, dans l'exemple des figures 4A à 4G, le dispositif photonique intègre différentes fonctions, par exemple une fonction d'émission lumineuse et une fonction de réception lumineuse. A titre d'exemple, le dispositif photonique intègre des diodes électroluminescentes (LED) et des diodes photosensibles.

La figure 4A illustre schématiquement la structure obtenue à l'issue d'étapes de formation d'un empilement actif de diode photosensible 103 sur la face supérieure d'un substrat 101. La structure comportant l'empilement 103 et le substrat 101 est par exemple similaire à ce qui a été décrit ci-dessus en relation avec la figure 1A. De préférence, l'ordre des couches de l'empilement 103 est inversé par rapport à l'exemple de la figure 1A. Pour cela, les couches de l'empilement 103 peuvent être épitaxiées dans l'ordre inverse de ce qui a été décrit dans l'exemple de la figure 1A, ou l'empilement peut être retourné et fixé par collage sur un substrat de support.

La figure 4A illustre de plus une étape de dépôt d'une couche diélectrique 151, par exemple en oxyde de silicium ou en nitrure de silicium, sur et en contact avec la face supérieure de l'empilement actif de diode photosensible 103. Dans cet exemple, la couche diélectrique 151 s'étend de façon continue et avec une épaisseur sensiblement uniforme sur toute la surface supérieure de l'empilement 103.

La figure 4A illustre en outre une étape de dépôt d'une couche métallique 153, par exemple en titane, sur et en contact avec la face supérieure de la couche diélectrique 151. Dans cet exemple, la couche métallique 153 s'étend de façon continue et avec une épaisseur sensiblement uniforme sur toute la surface supérieure de l'empilement 103.

La figure 4B illustre schématiquement la structure obtenue à l'issue d'étapes de formation d'un empilement actif de LED 163 sur la face supérieure d'un substrat 161.

L'empilement 163 est de préférence un empilement de couches semiconductrices inorganiques. L'empilement 163 comprend par exemple une ou plusieurs couches en un matériau semiconducteur de type III-V. L'empilement 163 est par exemple un empilement actif de LED adapté à émettre de la lumière visible, par exemple majoritairement de la lumière bleue. A titre d'exemple, l'empilement 163 est un empilement actif de LED au nitrure de gallium (GaN). A titre d'exemple, l'empilement 163 comprend, dans l'ordre à partir de la face supérieure du substrat 161 (non détaillées sur la figure), une couche semiconductrice dopée de type N, formant une couche de cathode de l'empilement de LED, une couche active, et une couche semiconductrice dopée de type P, formant une couche d'anode de l'empilement de LED. La couche active est par exemple un empilement à puits quantiques multiples. Le substrat 161 est par exemple en silicium.

La figure 4B illustre en outre une étape de dépôt d'une couche métallique 165 sur et en contact avec la face supérieure de l'empilement actif de LED 163. La couche 165 est par exemple en le même matériau que la couche 153, par exemple en titane. A ce stade, la couche métallique 165 s'étend de façon continue et avec une épaisseur sensiblement uniforme sur toute la surface supérieure de l'empilement actif de LED 163.

A ce stade, chacune des couches de l'empilement actif de diode photosensible 103 s'étend par exemple de façon continue et avec une épaisseur sensiblement uniforme sur toute la surface supérieure du substrat 101. De plus, chacune des couches de l'empilement actif de LED 163 s'étend par exemple de façon continue et avec une épaisseur sensiblement uniforme sur toute la surface supérieure du substrat 161. Les substrats 101 et 161 ont par exemple sensiblement les mêmes dimensions latérales.

La figure 4C illustre la structure obtenue à l'issue d'une étape de report et de fixation de l'empilement actif de diode photosensible 103 sur l'empilement actif de LED 163, puis de retrait du substrat 101. Lors de cette étape, l'empilement actif de diode photosensible 103 est reporté sur l'empilement actif de LED 163, en utilisant le substrat 101 comme poignée de support. Sur la figure 4C, la structure comportant le substrat 101 et l'empilement 103 est retournée par rapport à l'orientation de la figure 4A. L'empilement 103 est ensuite fixé sur l'empilement 163. Dans cet exemple, l'empilement 103 est fixé par collage direct pleine plaque de la face inférieure (dans l'orientation de la figure 4C, correspondant à la face supérieure dans l'orientation de la figure 4A) de la couche métallique 153, sur la face supérieure (dans l'orientation de la figure 4C, correspondant à la face supérieure dans l'orientation de la figure 4B) de la couche métallique 165. Le substrat 101 est ensuite retiré, par exemple par meulage et/ou gravure chimique, de façon à libérer l'accès à la face supérieure de l'empilement 103.

La figure 4D illustre la structure obtenue à l'issue d'étapes de formation de diodes photosensibles élémentaires dans l'empilement 103, identiques ou similaires à ce qui a été décrit ci-dessus en relation avec la figure 1B.

La figure 4D illustre en outre une étape de dépôt d'une couche métallique 111, par exemple en titane, sur la face supérieure du dispositif photonique ainsi obtenu. La couche 111 s'étend par exemple de façon continue et avec une épaisseur sensiblement uniforme sur toute la surface du substrat 161. Dans cet exemple, la couche métallique 111 est en contact, par sa face inférieure, avec la face supérieure de la couche diélectrique 107, et avec la face supérieure des métallisations 109. Ainsi, à ce stade, les métallisations de contact d'anode 109 des diodes sont toutes connectées les unes aux autres par l'intermédiaire de la couche métallique 111.

La suite du procédé est similaire à ce qui a été décrit ci-dessus en relation avec les figures 1C à 1J.

La figure 4E illustre la structure obtenue après la fixation de la poignée de support 150 sur la face de l'empilement d'interconnexion 145 du dispositif électronique opposée au dispositif photonique (à savoir la face supérieure de l'empilement d'interconnexion 145 dans l'orientation de la figure 4E). On notera que sur la figure 4E, le via 143c (figure 1J) contactant la région semiconductrice de cathode de l'empilement 103 n'a pas été représenté. Sur la figure 4E, on a en outre représenté un via conducteur 143d, isolé latéralement, s'étendant verticalement à travers les couches 123, 133, 135, 111, 107, 103 et 151, et venant contacter la couche métallique 153.

La figure 4F illustre une étape de retrait du substrat 161, de façon à exposer la face de l'empilement actif de LED 163 opposée à la couche métallique 165, suivie d'une étape de dépôt d'une couche conductrice 171 sur et en contact avec la face de l'empilement actif de LED 163 opposée à la couche métallique 165. Sur la figure 4F, l'assemblage est retourné par rapport à l'orientation de la figure 4E. Ainsi, sur cette figure, la couche conductrice 171 est disposée du côté de la face supérieure de l'empilement actif de LED 163.

La couche 171 est par exemple en un matériau conducteur transparent, par exemple de l'oxyde d'indium étain (ITO), ou en un métal suffisamment mince pour être transparent, par exemple de l'argent. A ce stade, la couche métallique 171 s'étend par exemple de façon continue et avec une épaisseur sensiblement uniforme sur toute la surface supérieure de l'empilement actif de LED 163.

La figure 4G illustre la structure obtenue à l'issue d'une étape de gravure localisée de l'empilement formé par la couche métallique 171, l'empilement actif de LED 163, la couche métallique 165 et la couche métallique 153. Lors de cette étape, seuls sont conservés des pavés 181 de l'empilement actif de LED 163, correspondant respectivement aux différentes LED du dispositif. La portion de l'empilement des couches métalliques 165 et 153 située sous chaque LED 181 forme une première électrode, par exemple une électrode d'anode, de la LED, et est connectée électriquement à une métallisation de l'empilement d'interconnexion 145 du circuit intégré de contrôle par l'intermédiaire d'un via 143d. La portion de la couche conductrice 171 située sur chaque LED 181 forme une deuxième électrode, par exemple une électrode de cathode, de la LED.

La figure 4G illustre en outre une étape de passivation des flancs des LED 181. Lors de cette étape, une couche 183 d'un matériau isolant, par exemple de l'oxyde de silicium ou du nitrure de silicium, est déposée de façon conforme du côté de la face supérieure de la structure, c'est-à-dire sur la face supérieure de la couche isolante 151 et de la couche conductrice supérieure 171, et sur les flancs des LED 181 et des couches conductrices 171, 165 et 153. Une étape de gravure anisotrope verticale peut ensuite être mise en oeuvre pour retirer les portions horizontales de la couche 183, en conservant les portions verticales de la couche 183, revêtant les flancs des LED 161 et des couches conductrices 171, 165 et 153.

La figure 4G illustre en outre une étape de formation d'une métallisation 185 connectant la face supérieure de chaque LED 181 à une métallisation de l'empilement d'interconnexion 145. Dans cet exemple, la métallisation 185 s'étend le long du flanc de la LED 181, à travers les couches 151, 103 et 107, et à travers une tranchée isolante 141. Dans l'exemple représenté, la métallisation 185 est en contact, latéralement, avec l'empilement actif de photodiode 103. Ainsi, dans cet exemple, la métallisation 185 forme une métallisation de contact commune aux LED et aux photodiodes, par exemple une métallisation de cathode commune. A titre de variante (non représentée), la métallisation 185 peut être isolée latéralement de l'empilement actif de photodiode 103.

Le procédé des figures 4A à 4G peut être étendu à la réalisation d'un dispositif optoélectronique intégrant plus de deux fonctions photoniques différentes.

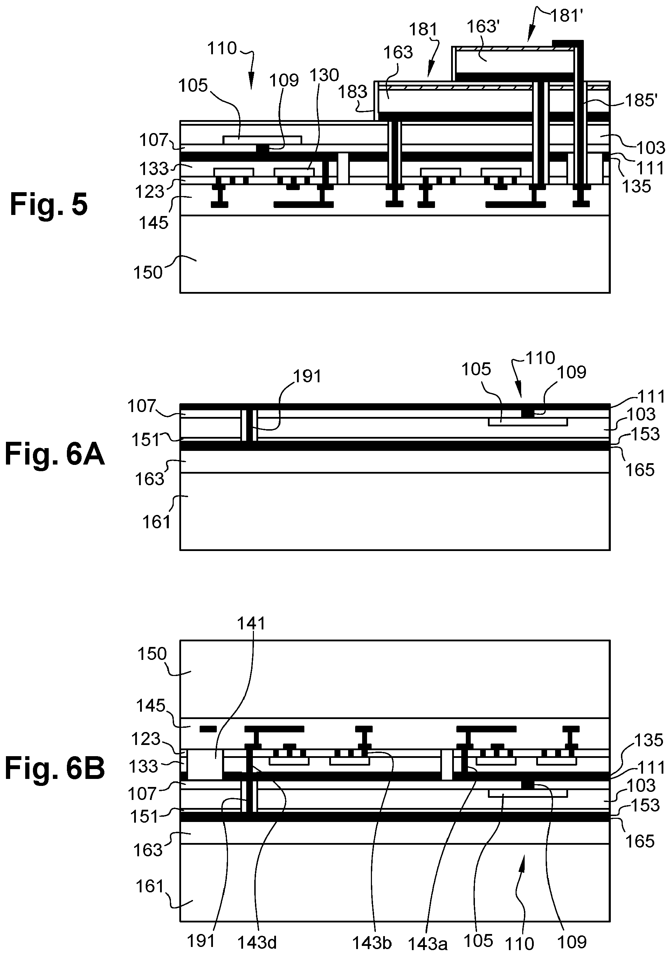

La figure 5 illustre schématiquement un exemple d'un dispositif optoélectronique dans lequel le dispositif photonique intègre des diodes électroluminescentes 181 adaptées à émettre à une première longueur d'onde, des diodes électroluminescentes 181' adaptées à émettre à une deuxième longueur d'onde, et des diodes photosensibles 110.

Pour cela, on forme une structure photonique de départ comportant un empilement actif de diode photosensible 103 revêtu, du côté d'une face, par un premier empilement actif de LED 163, l'empilement actif de LED 163 étant lui-même revêtu par un deuxième empilement actif de LED 163'.

Dans le dispositif final, tel qu'illustré par la figure 5, les LED 181 correspondent à des portions de l'empilement actif de LED 163 en vis-à-vis desquelles l'empilement actif de LED 163' a été retiré, et les LED 181' correspondent à des portions de l'empilement actif de LED 163' surmontant des portions de l'empilement actif de LED 163. Sur la figure 5, la métallisation 185 contactant la face supérieure des LED 181 n'est pas visible. Une métallisation 185' reliant la face supérieure des LED 181' à l'empilement d'interconnexion 145 a en revanche été représentée.

On notera que les variantes des figures 4A à 4G et 5 peuvent être combinées avec les variantes des figures 2A et 2B ou 3A et 3B.

Les figures 6A et 6B sont des vues en coupe illustrant des étapes d'une variante de mise en oeuvre du procédé des figures 4A à 4G.

Les étapes initiales du procédé sont identiques ou similaires à ce qui a été décrit en relation avec les figures 4A à 4D, à la différence près que, avant de déposer la couche métallique de collage 111, on vient former un via conducteur 191, isolé latéralement, s'étendant verticalement à travers les couches diélectriques 107 et 151 et à travers l'empilement actif 103. Le via 191 est en contact, par sa face inférieure, avec la face supérieure de la couche métallique 153. A titre d'exemple, un via 191 est formé en vis-à-vis de chaque emplacement de LED 181 du dispositif. La couche métallique 111 est ensuite déposée sur la face supérieure de la structure. A ce stade, chaque via 191 est en contact, par sa face supérieure, avec la face inférieure de la couche métallique 111.

La suite du procédé est similaire à ce qui a été décrit précédemment, à la différence près que, dans cet exemple, le via 143d ne traverse pas l'empilement actif de diode photosensible 103 mais débouche sur la face supérieure de la couche métallique 135.

La figure 6B représente la structure intermédiaire obtenue après la fixation de la poignée de support 150 sur la face supérieure de l'empilement d'interconnexion 145. Le reste du procédé est similaire à ce qui a été décrit en relation avec les figures 4A à 4G. La connexion sur l'électrode 153 de chaque LED 181 est ainsi réalisée par l'intermédiaire du via 143d et du via 191. On notera qu'en pratique et contrairement à ce qui est représenté sur la figure, les vias 191 et 143d ne sont pas nécessairement alignés verticalement, ces derniers étant connectés électriquement l'un à l'autre par l'intermédiaire des couches métalliques 111 et 135.

Un avantage de la variante des figures 6A et 6B, lié à la réalisation séquentielle de la connexion électrique sur l'empilement actif de LED 163, est de permettre de réaliser indépendamment les vias 143d et 191, et donc, éventuellement, de les désaligner verticalement. Ceci permet de limiter l'impact d'un désalignement dû aux collages successifs entre les pixels des deux fonctions (diodes photosensibles et LED dans cet exemple) du dispositif photonique d'une part, et les composants électroniques d'autre part. Cette variante permet notamment d'augmenter la densité de fonction photonique et/ou électronique par unité de surface.

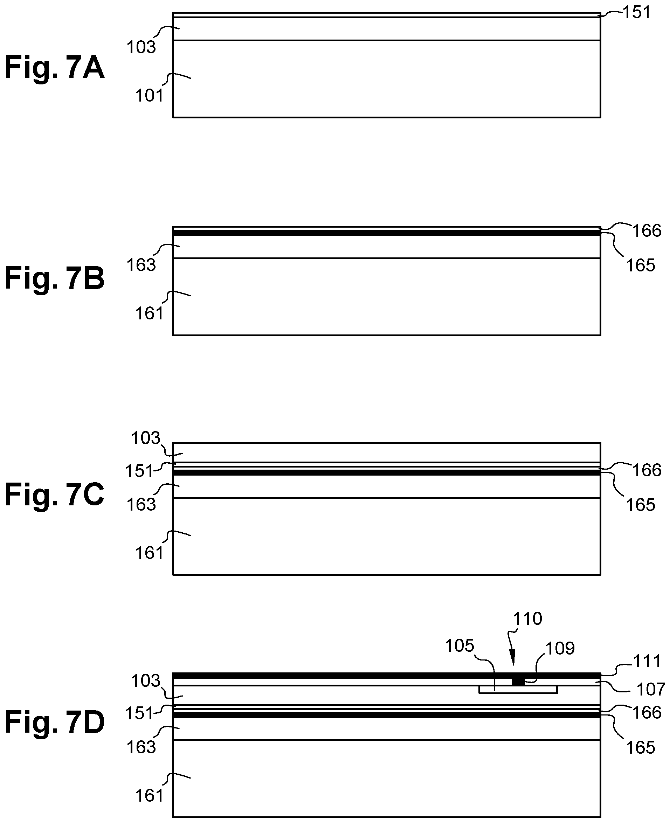

Les figures 7A, 7B, 7C et 7D sont des vues en coupe illustrant des étapes d'une autre variante du procédé de fabrication d'un dispositif optoélectronique décrit en relation avec les figures 4A à 4G.

Le procédé des figures 7A à 7D diffère du procédé des figures 4A à 4G principalement par la nature du collage entre l'empilement actif de diode photosensible 103 et l'empilement actif de LED 163. Dans cet exemple, le collage entre l'empilement actif de diodes photosensible 103 et l'empilement actif de LED 163 est un collage direct diélectrique-diélectrique pleine plaque, par exemple un collage direct oxyde-oxyde.

La figure 7A illustre schématiquement la structure obtenue à l'issue d'étapes de formation d'un empilement actif de diode photosensible 103 sur la face supérieure d'un substrat 101. La structure comportant l'empilement 103 et le substrat 101 est par exemple similaire à ce qui a été décrit ci-dessus en relation avec la figure 1A.

La figure 7A illustre de plus une étape de dépôt d'une couche diélectrique 151, par exemple en oxyde de silicium, sur et en contact avec la face supérieure de l'empilement actif de diode photosensible 103. Dans cet exemple, la couche diélectrique 151 s'étend de façon continue et avec une épaisseur sensiblement uniforme sur toute la surface supérieure de l'empilement 103.

La figure 7B illustre schématiquement la structure obtenue à l'issue d'étapes de formation d'un empilement actif de LED 163 sur la face supérieure d'un substrat 161.

L'empilement 163 est par exemple identique ou similaire à ce qui a été décrit ci-dessus en relation avec la figure 4B.

La figure 7B illustre en outre une étape de dépôt d'une couche métallique 165 sur et en contact avec la face supérieure de l'empilement actif de LED 163. A ce stade, la couche métallique 165 s'étend de façon continue et avec une épaisseur sensiblement uniforme sur toute la surface supérieure de l'empilement actif de LED 163. On notera que dans cet exemple, la couche métallique 165 n'a pas de fonction de collage moléculaire, ce qui libère une contrainte quant au choix des matériaux pouvant être utilisés pour former cette couche. A titre d'exemple, la couche 165 est en titane, en aluminium, en cuivre, en tungstène, ou en un alliage d'un ou plusieurs de ces matériaux. A titre de variante, la couche 165 peut être en tout autre matériau conducteur adapté, par exemple en un matériau semiconducteur dopé, par exemple du silicium ou du germanium.

La figure 7B illustre de plus une étape de dépôt d'une couche diélectrique 166, par exemple en le même matériau que la couche diélectrique 151, sur et en contact avec la face supérieure de la couche métallique 165. A ce stade, la couche diélectrique 166 s'étend par exemple de façon continue et avec une épaisseur sensiblement uniforme sur toute la surface supérieure de l'empilement actif de LED 163.

La figure 7C illustre la structure obtenue à l'issue d'une étape de report et de fixation de l'empilement actif de diode photosensible 103 sur l'empilement actif de LED 163, puis de retrait du substrat 101. Lors de cette étape, l'empilement actif de diode photosensible 103 est reporté sur l'empilement actif de LED 163, en utilisant le substrat 101 comme poignée de support. Sur la figure 7C, la structure comportant le substrat 101 et l'empilement 103 est retournée par rapport à l'orientation de la figure 7A. L'empilement 103 est ensuite fixé sur l'empilement 163. Dans cet exemple, l'empilement 103 est fixé par collage direct pleine plaque de la face inférieure (dans l'orientation de la figure 7C, correspondant à la face supérieure dans l'orientation de la figure 7A) de la couche diélectrique 151, sur la face supérieure (dans l'orientation de la figure 7C, correspondant à la face supérieure dans l'orientation de la figure 7B) de la couche diélectrique 166. Le substrat 101 est ensuite retiré de façon à libérer l'accès à la face supérieure de l'empilement 103.

La figure 7D illustre la structure obtenue à l'issue des étapes de formation des diodes photosensibles élémentaires 110 dans l'empilement 103, puis de dépôt de la couche métallique 111 sur la face supérieure du dispositif photonique.

Les étapes suivantes sont identiques ou similaires à ce qui a été décrit précédemment.

A titre de variante, les couches diélectriques 151 et 166 peuvent être remplacées par des couches d'un matériau semiconducteur, par exemple non dopé de façon à présenter une résistivité électrique relativement élevée, par exemple du silicium ou du germanium non dopé. Le collage réalisé entre l'empilement actif de diode photosensible 103 et l'empilement actif de LED 163 est alors un collage semiconducteur-semiconducteur pleine plaque.

On notera que la variante des figures 7A à 7D et la variante des figures 6A et 6B peuvent être combinées. De plus, ces variantes, qu'elles soient prises seules ou en combinaison, peuvent être combinées avec les variantes des figures 2A et 2B ou 3A et 3B.

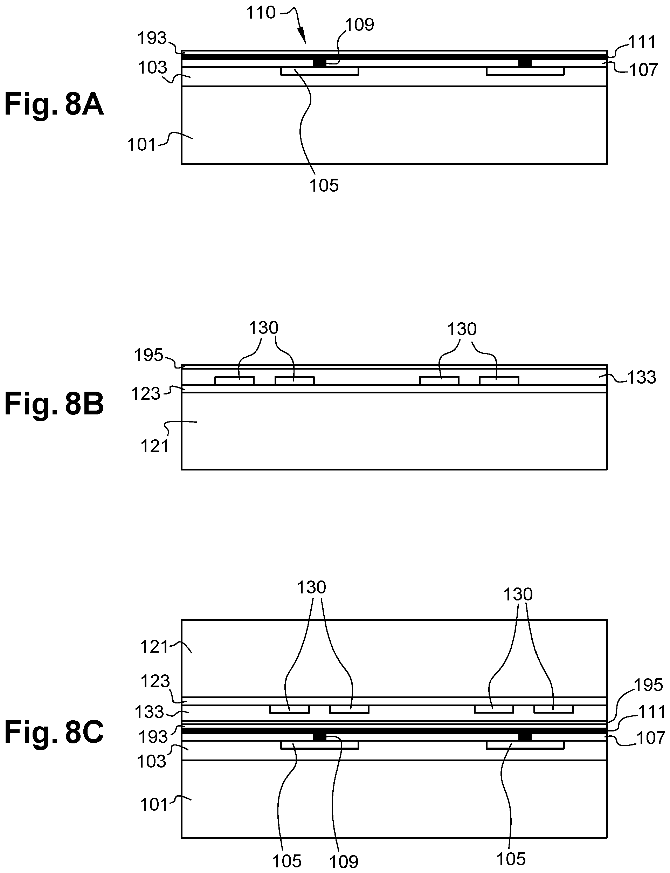

Les figures 8A, 8B et 8C sont des vues en coupe illustrant des étapes d'une autre variante du procédé de fabrication d'un dispositif optoélectronique décrit en relation avec les figures 1A à 1K.

Le procédé des figures 8A à 8C diffère du procédé des figures 1A à 1K principalement par la nature du collage entre le dispositif photonique et le dispositif électronique. Dans cet exemple, le collage entre le dispositif photonique et le dispositif électronique est un collage direct diélectrique-diélectrique pleine plaque, par exemple un collage direct oxyde-oxyde.

La figure 8A illustre une structure de dispositif photonique identique ou similaire à la structure de la figure 1B, mais dans laquelle une couche diélectrique 193, par exemple en oxyde de silicium, a été déposée sur et en contact avec la face supérieure de la couche métallique 111. La couche diélectrique 193 s'étend par exemple de façon continue et avec une épaisseur sensiblement uniforme sur toute la surface supérieure de la couche métallique 111. Dans cet exemple, la couche métallique 111 peut être en titane, en aluminium, en cuivre, en tungstène, ou en un alliage d'un ou plusieurs de ces matériaux.

La figure 8B illustre une structure de dispositif électronique identique ou similaire à la structure de la figure 1D, mais dans laquelle la couche métallique supérieure 135 est remplacée par une couche diélectrique 195, par exemple en le même matériau que la couche diélectrique 193, par exemple en oxyde de silicium.

La figure 8C illustre une étape ultérieure de report et de fixation du dispositif électronique de la figure 8B sur la face supérieure du dispositif photonique de la figure 8A. Sur la figure 8C, le dispositif électronique est retourné par rapport à l'orientation de la figure 8B. L'orientation du dispositif photonique est en revanche inchangée par rapport à l'orientation de la figure 8A.

Le dispositif électronique est fixé sur le dispositif photonique par collage direct pleine plaque de la face inférieure de la couche diélectrique 195 sur la face supérieure de la couche diélectrique 193.

La suite du procédé est identique ou similaire à ce qui a été décrit ci-dessus en relation avec les figures 1F à 1K.

A titre de variante, les couches diélectriques 193 et 195 peuvent être remplacées par des couches d'un matériau semiconducteur, par exemple non dopé de façon à présenter une résistivité électrique relativement élevée, par exemple du silicium ou du germanium non dopé. Le collage réalisé entre le dispositif photonique et le dispositif électronique est ainsi un collage direct semiconducteur-semiconducteur pleine plaque.

On notera que la variante des figures 8A à 8C peut être combinée avec les variantes des figures 2A et 2B, 3A et 3B, 4A à 4G, 5, 6A et 6B, et 7A à 7D.

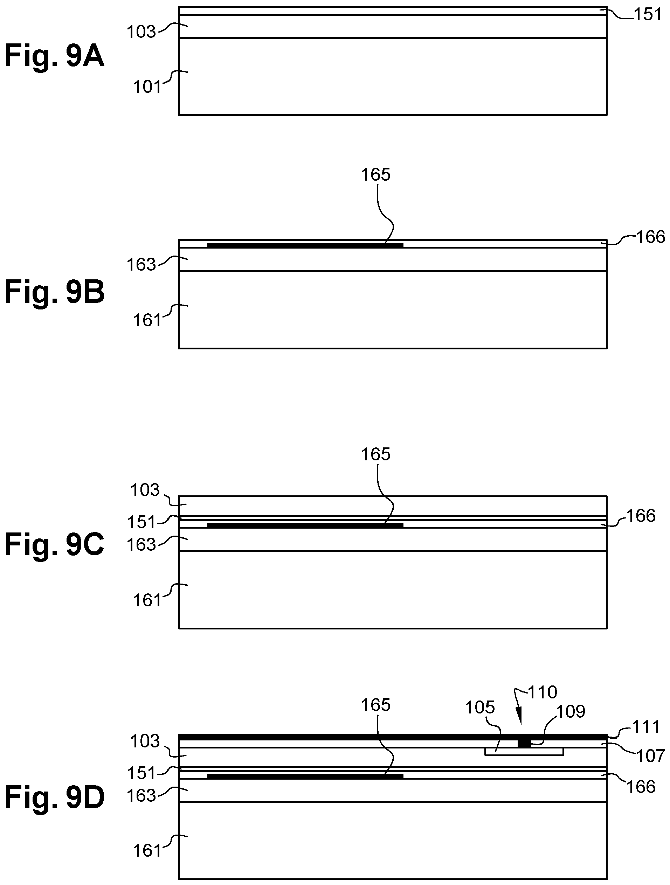

Les figures 9A, 9B, 9C et 9D sont des vues en coupe illustrant des étapes d'une variante de réalisation du procédé des figures 7A à 7D.

Le procédé des figures 9A à 9D diffère du procédé des figures 7A à 7D principalement en ce que, dans l'exemple des figures 9A à 9D la couche métallique 165 est structurée (paternée) de façon à définir les électrodes des LED, avant le collage de l'empilement actif de diode photosensible 103 sur l'empilement actif de LED 163.

La figure 9A illustre schématiquement la structure obtenue à l'issue d'étapes de formation d'un empilement actif de diode photosensible 103 sur la face supérieure d'un substrat 101, suivies d'une étape de dépôt d'une couche diélectrique 151, par exemple en oxyde de silicium, sur et en contact avec la face supérieure de l'empilement actif de diode photosensible 103. La structure de la figure 9A est par exemple similaire à ce qui a été décrit ci-dessus en relation avec la figure 7A.

La figure 9B illustre schématiquement la structure obtenue à l'issue d'étapes de formation d'un empilement actif de LED 163 sur la face supérieure d'un substrat 161. L'empilement 163 est par exemple identique ou similaire à ce qui a été décrit ci-dessus en relation avec la figure 7B.

La figure 9B illustre en outre une étape de dépôt puis de gravure localisée d'une couche métallique 165 sur et en contact avec la face supérieure de l'empilement actif de LED 163. La couche métallique 165 est d'abord déposée de façon continue et avec une épaisseur sensiblement uniforme sur toute la surface supérieure de l'empilement actif de LED 163. Une étape de gravure localisée est ensuite mise en oeuvre pour définir dans la couche 165 une pluralité d'électrodes disjointes correspondant chacune, dans le dispositif final, à une électrode inférieure (dans l'orientation de la figure 4G) d'une LED du dispositif photonique. En dehors desdites électrodes, la couche métallique 165 est retirée sur toute son épaisseur de façon à exposer la face supérieure de l'empilement actif de diode photosensible 103.

La figure 9B illustre en outre une étape de dépôt d'une couche diélectrique 166, par exemple en le même matériau que la couche diélectrique 151, par exemple en oxyde de silicium, sur la face supérieure de la structure obtenue après l'étape de structuration de la couche métallique 165. La couche diélectrique 166 peut être déposée avec une épaisseur supérieure à l'épaisseur de la couche métallique 165, puis planarisée. A l'issue de l'étape de planarisation, la couche diélectrique 166 s'étend de façon continue sur toute la surface supérieure du substrat 161.

La figure 9C illustre la structure obtenue à l'issue d'une étape de report et de fixation de l'empilement actif de diode photosensible 103 sur l'empilement actif de LED 163, puis de retrait du substrat 101. Lors de cette étape, l'empilement actif de diode photosensible 103 est reporté sur l'empilement actif de LED 163, en utilisant le substrat 101 comme poignée de support. Dans cet exemple, l'empilement 103 est fixé par collage direct pleine plaque de la face inférieure (dans l'orientation de la figure 9C, correspondant à la face supérieure dans l'orientation de la figure 9A) de la couche diélectrique 151, sur la face supérieure (dans l'orientation de la figure 9C, correspondant à la face supérieure dans l'orientation de la figure 9B) de la couche diélectrique 166. Le substrat 101 est ensuite retiré de façon à libérer l'accès à la face supérieure de l'empilement 103.

La figure 9D illustre la structure obtenue à l'issue des étapes de formation des diodes photosensibles élémentaires 110 dans l'empilement 103, puis de dépôt de la couche métallique 111 sur la face supérieure du dispositif photonique.

Les étapes suivantes sont identiques ou similaires à ce qui a été décrit précédemment.

Dans cette variante, dans la mesure où la couche métallique 165 a été retirée en dehors des emplacements des LED du dispositif, et si l'empilement actif de LED 163 est suffisamment transparent dans la gamme de longueurs d'onde de sensibilité de l'empilement actif de diode photosensible 103, l'empilement 163 peut ne pas être gravé en fin de procédé. Autrement dit, l'étape de structuration de l'empilement actif de LED 163 décrite en relation avec la figure 4G peut être omise. Ceci permet de simplifier le procédé de fabrication.

A titre de variante, les couches diélectriques 151 et 166 peuvent être remplacées par des couches d'un matériau semiconducteur, par exemple non dopé de façon à présenter une résistivité électrique relativement élevée, par exemple du silicium ou du germanium non dopé. Le collage réalisé entre l'empilement actif de diode photosensible 103 et l'empilement actif de LED 163 est ainsi un collage semiconducteur-semiconducteur pleine plaque.

De même que la variante des figures 7A à 7D, la variante des figures 9A à 9D peut être combinées avec les autres variantes présentées ci-dessus.

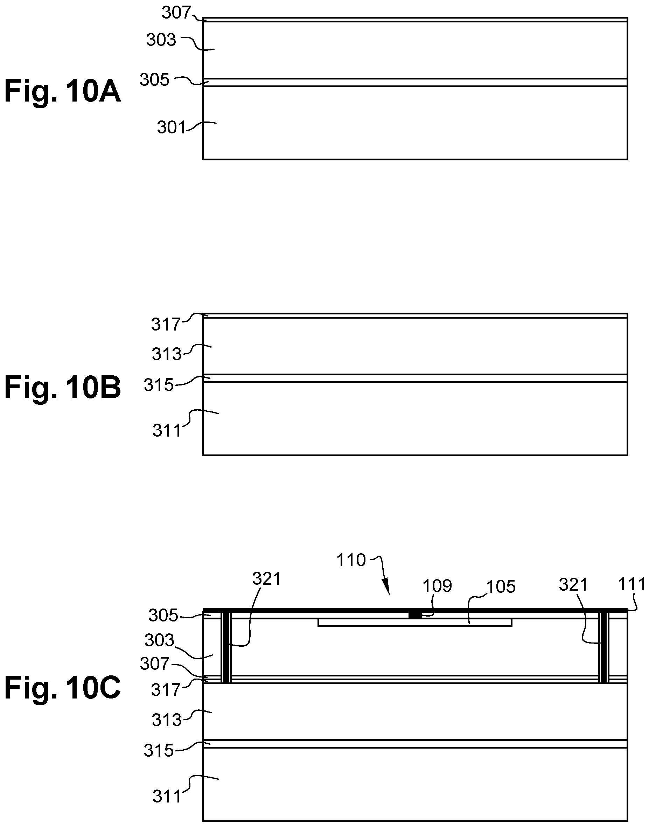

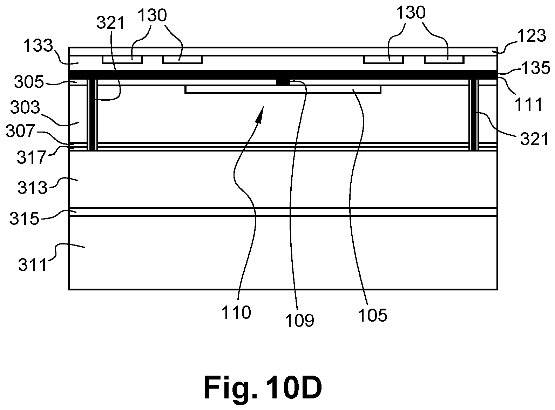

Les figures 10A, 10B, 10C et 10D sont des vues en coupe illustrant des étapes d'un autre exemple d'un procédé de fabrication d'un dispositif optoélectronique selon un mode de réalisation.

Dans cet exemple le dispositif photonique comprend un détecteur visible, par exemple à base de silicium, et un détecteur infrarouge, par exemple à base de matériaux semiconducteurs de type III-V, par exemple à base d'InGaAs, le détecteur visible et le détecteur infrarouge étant superposés.

La figure 10A illustre très schématiquement une première structure comportant un empilement actif de détecteur infrarouge 303, par exemple à base d'InGaAs, disposé sur un substrat de support 301, par exemple en silicium. Dans l'exemple représenté, une couche diélectrique 305, par exemple en oxyde de silicium, fait interface entre le substrat 301 et l'empilement 303. De plus, dans cet exemple, une couche diélectrique 307, par exemple en oxyde de silicium revêt la face supérieure de l'empilement 303.

La figure 10B illustre très schématiquement une deuxième structure comportant un capteur visible comportant une pluralité de pixels de détection de lumière visible (non détaillés sur la figure) formés dans et sur une couche semiconductrice 313, par exemple en silicium, disposée sur un substrat de support 311, par exemple en silicium. Dans l'exemple représenté, une couche diélectrique 315, par exemple en oxyde de silicium, fait interface entre le substrat 311 et la couche 313. L'empilement 311-315-313 est par exemple un substrat SOI. De plus, dans cet exemple, une couche diélectrique 317, par exemple en oxyde de silicium, revêt la face supérieure de la couche semiconductrice 313.

La figure 10C illustre la structure obtenue à l'issue d'une étape de report et de fixation de la structure de la figure 10A sur la structure de la figure 10B, puis de retrait du substrat 301. Dans cet exemple, la structure de la figure 10A est fixée par collage direct pleine plaque de la face inférieure (dans l'orientation de la figure 10C, correspondant à la face supérieure dans l'orientation de la figure 10A) de la couche diélectrique 307 sur la face supérieure (dans l'orientation de la figure 10C, correspondant à la face supérieure dans l'orientation de la figure 10B) de la couche 317.

Le substrat 301 est ensuite retiré de façon à exposer la face supérieure (dans l'orientation de la figure 10C) de la couche diélectrique 305. A titre de variante, la couche 305 n'est pas présente dans l'empilement initial de la figure 10A, et est déposée seulement après le retrait du substrat 301, à l'étape de la figure10C.

Dans l'exemple représenté, des vias conducteurs isolés 321, traversant verticalement la couche diélectrique 305, l'empilement actif 303 et les couches diélectriques 307 et 317, sont ensuite formés pour reprendre des contacts électriques sur les pixels du capteur visible.

La figure 10C illustre en outre des étapes de formation de diodes photosensibles 110 dans l'empilement actif de détecteur infrarouge 303. Pour chaque diode photosensible 110, on vient par exemple former une région localisée de type P 105 dans une couche supérieure de type N de l'empilement 303, la région 105 définissant une région d'anode de la diode photosensible.

La suite du procédé est similaire à ce qui a été décrit précédemment.

La figure 10D illustre la structure obtenue après report et fixation d'un dispositif électronique sur la face supérieure de la couche métallique 111, tel que décrit par exemple en relation avec les figures 1E et 1F.

Des étapes similaires à ce qui a été décrit ci-avant en relation avec les figures 1G à 1K peuvent ensuite être mises en oeuvre.

A titre d'exemple, après la fixation d'une poignée de support 150 du côté de la face du dispositif électronique opposée au dispositif photonique, le substrat 311 du capteur visible peut être retiré. Des éléments optiques (non représentés) tels que des filtres couleur et/ou infrarouge et/ou des microlentilles peuvent être formés du côté de la face de la couche semiconductrice 313 opposée à l'empilement actif de photodétecteur 303.

A titre de variante, non représentée, avant le report de la structure de la figure 10B sur la structure de la figure 10A, des éléments optiques, non représentés, par exemple des microlentilles, par exemple en silicium, et/ou des structures optiques de type méta-surfaces, par exemple en silicium, peuvent être formées du côté de la face supérieure de la couche diélectrique 317 de la structure de la figure 10B. De tels éléments optiques enterrés entre le capteur visible et le capteur infrarouge permettent de focaliser vers les photodiodes 110 du capteur infrarouge la lumière transmise par le capteur visible.

La variante de réalisation des figures 10A à 10D pourra être combinée notamment avec les variantes des figures 3A et 3B et 8A à 8C.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de matériaux et de dimensions décrits ci-dessus.

Enfin, la mise en oeuvre pratique des modes de réalisation et variantes décrits est à la portée de la personne du métier à partir des indications fonctionnelles données ci-dessus.

## Revendications

1. Procédé de fabrication d'un dispositif optoélectronique, comportant les étapes suivantes :
a) réaliser un dispositif photonique comportant une pluralité de composants photoniques (110 ; 210 ; 181 ; 181') formés dans et sur un empilement (103 ; 205 ; 163 ; 163') d'une ou plusieurs couches semiconductrices revêtant un premier substrat (101 ; 201 ; 161) ;
b) réaliser un dispositif électronique comportant une couche semiconductrice (125) revêtant un deuxième substrat (121) ;
c) après les étapes a) et b), fixer le dispositif électronique sur la face supérieure du dispositif photonique par collage direct, puis retirer le deuxième substrat (121) ;
d) après l'étape c), former, du côté de la face supérieure du dispositif électronique, des métallisations de connexion (143a, 143b, 143c ; 143d) électrique contactant des composants électroniques (130) du dispositif électronique et les composants photoniques (110 ; 210 ; 181 ; 181'), le procédé comportant en outre :
- après l'étape a) et avant l'étape c), une étape de dépôt d'une couche métallique (111) s'étendant de façon continue sur toute la surface supérieure du dispositif photonique ; et
- après l'étape c), une étape de formation, à partir de la face supérieure du dispositif électronique, d'une pluralité de tranchées isolantes (141) s'étendant verticalement à travers le dispositif électronique et la couche métallique (111), lesdites tranchées isolantes (141) délimitant dans la couche métallique (111) une pluralité d'électrodes isolées électriquement les unes des autres.

2. Procédé selon la revendication 1, comportant, avant l'étape c), la formation d'une pluralité de composants électroniques (130) dans et sur la couche semiconductrice (125) revêtant le deuxième substrat (121).

3. Procédé selon la revendication 1, comportant en outre, après l'étape c), la formation d'une pluralité de composants électroniques (130) dans et sur la couche semiconductrice (125).

4. Procédé selon l'une quelconque des revendications 1 à 3, dans lequel, à l'étape c), le dispositif électronique est fixé sur la face supérieure du dispositif photonique par collage direct pleine plaque métal-métal, diélectrique-diélectrique, ou semiconducteur-semiconducteur.

5. Procédé selon l'une quelconque des revendications 1 à 4, comportant en outre, après l'étape d), une étape de formation d'un empilement d'interconnexion (145) du côté de la face supérieure du dispositif électronique.

6. Procédé selon l'une quelconque des revendications 1 à 5, comportant en outre, après l'étape d), une étape de fixation, du côté de la face supérieure du premier dispositif électronique, d'un deuxième dispositif électronique comportant une pluralité de composants électroniques (130') formés dans et sur une couche semiconductrice (125') revêtant un troisième substrat (121').

7. Procédé selon l'une quelconque des revendications 1 à 6, dans lequel les composants photoniques comprennent des diodes photosensibles (110) et/ou des LED (181 ; 181').

8. Procédé selon l'une quelconque des revendications 1 à 6, dans lequel les composants photoniques comprennent des microbolomètres (210).

9. Procédé selon l'une quelconque des revendications 1 à 8, dans lequel l'étape a) comprend une étape de report et de fixation d'un premier empilement actif photonique (103) sur un deuxième empilement actif photonique (163).

10. Procédé selon la revendication 9, comportant, après la fixation du premier empilement actif photonique (103) sur le deuxième empilement actif photonique (163) et avant l'étape c), une étape de formation d'un via conducteur isolé (191) traversant le premier empilement actif photonique et contactant le deuxième empilement actif photonique (163).

11. Procédé selon la revendication 9 ou 10, dans lequel le premier empilement actif photonique (103) est un empilement actif de diode photosensible et le deuxième empilement actif photonique (163) est un empilement actif de LED.

12. Procédé selon la revendication 11, comportant la réalisation d'une métallisation de contact de cathode commune au premier empilement actif photonique (103) et au deuxième empilement actif photonique (163).

13. Procédé selon l'une quelconque des revendications 9 à 12, dans lequel le premier empilement actif photonique (103) est fixé sur le deuxième empilement actif photonique (163) par collage direct métal-métal ou par collage direct diélectrique-diélectrique ou par collage direct semiconducteur-semiconducteur.

14. Procédé selon l'une quelconque des revendications 9 à 13, comportant, avant la fixation du premier empilement actif photonique (103) sur le deuxième empilement actif photonique (163), une étape de dépôt d'une couche métallique (165) sur et en contact avec la face supérieure du deuxième empilement actif photonique (163).

15. Procédé selon la revendication 14, dans lequel, lors de la fixation du premier empilement actif photonique (103) sur le deuxième empilement actif photonique (163), ladite couche métallique (165) s'étend de façon continue sur toute la surface du deuxième empilement actif photonique (163).

16. Procédé selon la revendication 14, dans lequel, avant la fixation du premier empilement actif photonique (103) sur le deuxième empilement actif photonique (163), ladite couche métallique (165) est retirée localement par gravure de façon à définir une pluralité d'électrodes disjointes.

17. Procédé selon l'une quelconque des revendications 1 à 14, dans lequel le dispositif photonique comprend un capteur visible et un capteur infrarouge superposés, le capteur visible étant formé dans et sur une couche semiconductrice (313) et le capteur infrarouge étant formé dans et sur un empilement actif de détecteur infrarouge (303) .
